# EUROPEAN PATENT SPECIFICATION

(11) **EP 1 737 022 B1**
(45) Date of publication and mention of the grant of the patent: **19.12.2007**
(21) Application number: 06011214.1
(22) Date of filing: 31.05.2006
(51) Int. Cl.: H01L 21/00, G03F 7/20, G06F 19/00

(54) **Substrate processing system and substrate processing method**
Ein Substratverarbeitungssystem und ein Substratverarbeitungsverfahren
Un appareil et un procédé de traitement d'un substrat

(30) Priority: 21.06.2005 JP 2005180089
(43) Date of publication of application: 27.12.2006
(73) Proprietor: TOKYO ELECTRON LIMITED, Minato-ku Tokyo 107-8481 (JP)
(72) Inventor: Kaneko, Tomohiro, Koshi-shi, Kumamoto-ken (JP); Miyata, Akira, Koshi-shi Kumamoto-ken (JP)
(74) Representative: HOFFMANN EITLE

(56) References cited:
- JP-A- 2004 266 172
- US-A1- 2003 063 555
- US-A1- 2005 061 248

## Description

### BACKGROUND OF THE INVENTION

### Field of the Invention

The present invention relates to a substrate processing system and a substrate processing method for processing a plurality of substrates on an in-line system including a plurality of processing apparatuses in a single-substrate processing mode.

### Description of the Related Art

In a photolithographic process included in an electronic device manufacturing process for manufacturing an electronic device, such as a semiconductor device, a resist film forming and developing apparatus for applying a liquid resist (hereinafter, referred to simply as "resist") to a substrate, such as a wafer, in a resist film and processing the resist film by a developing process, and an exposure unit for processing the substrate coated with the resist film by an exposure process are used in combination to achieve an in-line processing operation.

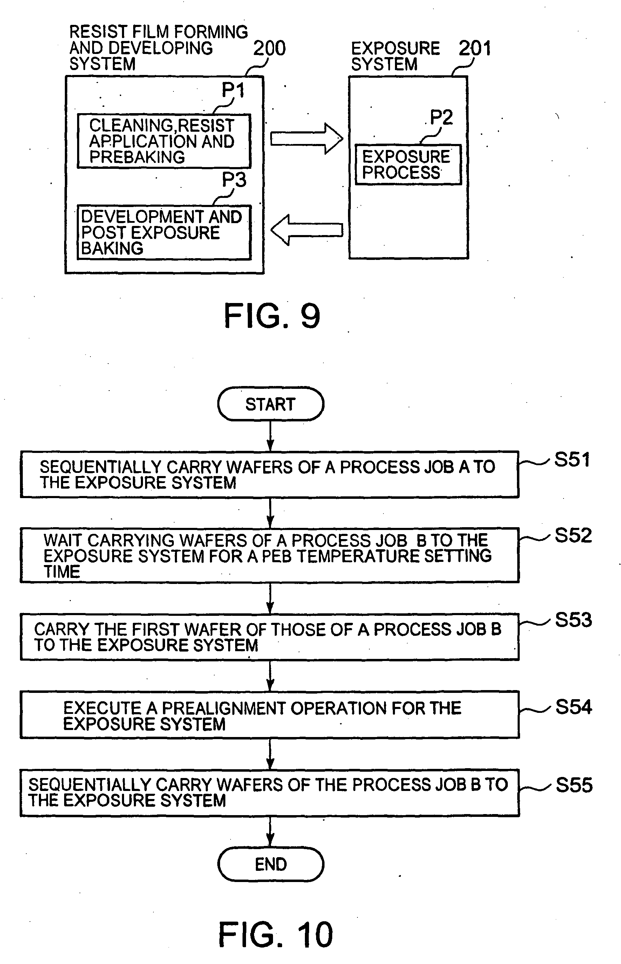

Referring to Fig. 9 typically showing a substrate processing system, a resist film forming and developing apparatus 200 carries out a first processing process P1 including a series of steps including a cleaning step, a dehydrating and baking step, an adhesion step (hydrophobicity imparting step), a resist film forming step and a prebaking step.

Then, the substrate is transferred to an exposure unit 201. The exposure unit 201 processes the substrate by a second processing process P2, namely, an exposure process. The exposed substrate is returned to the resist film forming and developing apparatus 200. Then, resist film forming and developing apparatus 200 carries out a third processing process P3 including a series of steps including a prebaking step, a developing step and a post baking step to shape the resist film in a predetermined circuit pattern.

In such an in-line process, a plurality of substrates are handled in a lot, and processing conditions (hereinafter, referred to as "process recipes") are determined for the lot. Those substrates are processed in a lot. Substrates of a group to be subjected to a series of processing steps of a process will be referred to as a process job (PJ). Such an in-line photolithographic process is mentioned in JP-A 2000-235949 (Patent document 1).

This in-line photolithographic process is carried out by the cooperative operation of a resist film forming and developing system and an exposure system. From the viewpoint of throughput and productivity, the further improvement of such a cooperative operation is one of important future subjects. Resist films formed on different wafers are likely to an acid reaction in different modes of progress unless the wafers are transferred smoothly between the resist film forming and developing system and the exposure system. If the resist film forming and developing system and the exposure system do not cooperate properly, the improper cooperation of the resist film forming and developing system and the exposure system affects the width of lines of a pattern adversely and reduces yield.

A conventional method of cooperation is very likely to cause the foregoing problems. For example, the in-line process to be carried out by the resist film forming and developing system 200 and the exposure system 201 shown in Fig. 9 has a problem that it takes an excessively long time for changing process conditions for some one of the process jobs.

For example, Fig. 10 is a flow chart of a transfer procedure for sequentially transferring wafers from the resist film forming and developing system 200 to the exposure system 201 in processing a process job A by a process defined by process conditions and in processing a process job B by a process defined by process conditions different from those defining process for processing the process A.

Referring to Fig. 10, wafers of a process job A prebaked by a first process P1 are transferred sequentially from the resist film forming and developing system 200 to the exposure system 201 in step S51.

After all the wafers of the process job A have been carried to the exposure system 201, the resist film forming and developing system 200 is kept waiting before carrying wafers of a process job B to the exposure system 201. A process temperature for a postexposure baking step (PEB step) to be carried out in a third process P3 after exposure needs to be set according to process conditions. Wafers cannot be processed for a process temperature setting operation for setting the process temperature. Therefore, the resist film forming and developing system 200 interrupts carrying the wafers of the process job B to the exposure system 200 for the process temperature setting time of, for example, 40 s in step S52.

After the operation of the resist film forming and developing system 200 has been interrupted for the process temperature setting time in step S52, the leading wafer of the process job B is carried to the exposure system 201 in step S53. Then, a prealignment step of the second process P2 is performed, for example, for 30 s in step S54. This 30 s is a time necessary for adjusting the exposure system 201.

After the realignment step for adjusting the exposure system 201 has been completed, the wafers of the process job B are carried sequentially to the exposure system 201 in step S55

When the wafers are processed by the processing procedure represented by the flow chart shown in Fig. 10, a time interval between the end of processing the process jobs A and the start of processing the process job B is a long time of about 70s which is the sum of the times needed by steps S52 and S54.

Such a long time interval is needed because respective operations of the resist film forming and developing system 201 and the exposure system 201 are controlled individually. The resist film forming and developing system 200 adds 40 s, which is needed after the wafer has been carried out of the exposure system 201, to a time for carrying the wafer to the exposure system 201 The time of 30 s is needed to adjust the exposure system 201. Consequently, the time necessary for changing the process jobs needs to include those times and hence throughput decreases.

The method of making the resist film forming and developing system and the exposure system cooperate of the related art cannot fix a time needed before starting the postexposure baking process (PEB process), namely, a postexposure delay time (PED time), because the respective process cycle times of the resist film forming and developing system 200 and the exposure system 201 are different from each other. Therefore, the wafers are held for different postexposure delay times (PED times), respectively, before being subjected to the postexposure baking step (PEB step). Consequently, the resist film formed on the wafers undergo different acid reactions, respectively, circuit patterns formed on the wafers differ from each other in the width of lines forming the circuit patterns and yield is likely to decrease.

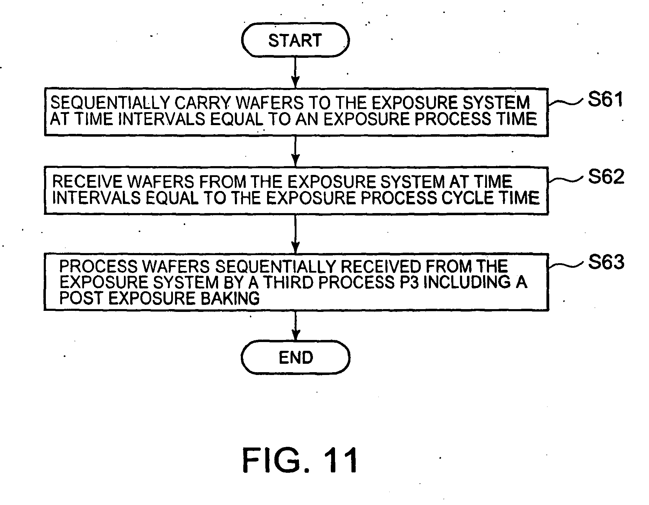

Fig. 11 shows a known process including steps from a carrying step of carrying a wafer from the resist film forming and developing system 200 to the exposure system 201 to a postexposure baking step (PEB step) in a flow chart by way of example.

Referring to the flow chart shown in Fig. 11, the resist film forming and developing system 200 carries wafers sequentially to the exposure system 201 at time intervals equal to a time needed by the exposure system 201 for processing one wafer, i.e., a process cycle time of, for example, 40 s needed to carry out the second process P2 in step S61.

The resist film forming and developing system 200 receives wafers from the exposure system 201 at time intervals equal to the process cycle time of 40 s in step S62.

The resist film forming and developing system 200 processes wafers sequentially received from the exposure system 201 by a third process P3 including predevelopment, development and postexposure baking (PEB) in step S63.

Suppose that the process cycle time of the PEB step of the third process P3 is, for example, 60 s. This process cycle time is longer than the process cycle time needed by the exposure system 201. Therefore, the resist film forming and developing system 201 is unable to process the wafers received from the exposure system 201 by PEB without delay and the wafers piles up in the resist film forming and developing system 200. Consequently, throughput decreases and the wafers are kept for different times, respectively, before PEB.

To deal with the stagnation of the flow of the wafers in the resist film forming and developing system 200, the resist film forming and developing system 200 is provided with a piece of storage hardware, such as an out buffer, to store the wafers temporarily. However, the hardware increases the cost of the resist film forming and developing system 200 and increases footprints. The additional operations of a carrying arm decreases throughput.

Japanese patent application JP 2004 266172 A discloses a coating and developing device and an exposure device. The devices are connected in-line. The coating and developing device can request delivery of profile information from the exposure device. A software can be selected by the coating and developing device depending on the received profile information.

Patent application US 2003/0063555 A1 discloses a production system for producing a composite product such as a semiconductor substrate. A first and a second production lines are interrelated and a plurality of works in process are put on the production line. The production system is arranged so that occurrence of a product defect or malfunction due to a contamination at a manufacturing stage of a composite product is prevented.

Patent application US 2005/0061248 A1 discloses a substrate processing apparatus for performing a predetermined process on substrates. Interferences between two lots of substrates is prevented by interference prediction through virtually executing transport cycles. If interference occurs, a next transport cycle is skipped.

### SUMMARY OF THE INVENTION

The present invention has been made in view of the foregoing circumstances and it is an object of the present invention to provide a substrate processing system including first and second systems in combination for processing a plurality of substrates by a single-wafer processing method by the cooperation of the first and the second system and capable of restricting increase in cost and footprints and decrease in yield and throughput, and to provide a substrate processing method to be carried out by the same substrate processing system.

The present invention provides a substrate processing system according to claim 1.

Thus the first and the second processing system can be informed of the processing times needed by the second and the first processing system, respectively. The information can be used for controlling the carrying operations to improve the cooperation of the first and the second processing system to achieve an in-line process.

Furthermore, the second processing system obtains the information about the setting time needed by the first processing system and can determine a shortest necessary time interval between operations for sending out the substrates. Consequently, the first and the second processing system do not need any waiting time, the operation needs to be interrupted only for the shortest necessary time interval and hence the reduction of throughput can be restricted.

Desirably, the substrate processing system further includes a general control means for controlling operations of the first and the second processing system, wherein the general control means gives the information about the processing time needed by the first processing system through the second communication means to the second control means of the second processing system or gives the information about the processing time needed by the second processing system through the first communication means to the first control means of the first processing system.

Thus the information about the processing time needed by the first processing system and the information about the processing time needed by the second processing system can be efficiently given to the second and the first processing system, respectively.

Desirably, the first control means informs the second control means of a first process cycle time needed for processing one substrate by the third process, the second control means compares the first process cycle time received from the first control means and a second process cycle time needed for processing one substrate by the second process, the second control means selects the longer one of the first and the second process cycle time to use the selected process cycle time as a time interval at which the substrates are carried sequentially from the second processing system to the first processing system.

Thus the second processing system can obtain the process cycle time needed by the first processing system and can determine the shortest necessary time interval at which the substrates are carried to the first processing system. Consequently, the stagnation of the flow of the substrates due to the different process cycle times and the reduction of yield due to the different PED times can be prevented. Since the substrate processing system does not need any additional hardware, such as an out buffer, cost and footprints can be reduced.

Desirably, the second control means informs the first control means of a second process cycle time needed for processing one substrate by the second process, the control means compares the second process cycle time received from the second control means and a first process cycle time needed for processing one substrate by the third process, and the first control means selects the longer one of the first and the second process cycle time to use the selected process cycle time as a time interval at which substrates are carried sequentially from the first processing system to the second processing system.

Thus the first processing system obtains the process cycle time needed by the second processing system and can set a shortest necessary time interval at which substrates are carried to the second processing system. Consequently, the stagnation of the flow of the substrates due to the different process cycle times and the reduction of yield due to the different PED times can be prevented. Since the substrate processing system does not need any additional hardware, such as an out buffer, cost and footprints can be reduced.

The present invention provides a substrate processing method according to claim 5.

Thus the first and the second processing system can know the processing times needed by the second processing system and the first processing system, respectively. The information can be used for controlling the carrying operations to improve the cooperation of the first and the second processing system to achieve an in-line process.

Furthermore, the second processing system obtains the information about the setting time needed by the first processing system and can determine a shortest necessary time interval between operations for sending out the substrates. Consequently, the first and the second processing system do not need any waiting time, the operation needs to be interrupted only for the shortest necessary time interval and hence the reduction of throughput can be restricted.

Desirably, a general control means for controlling operations of the first and the second processing system gives the information about the processing time needed by the first processing system to the second processing system or gives the information about the processing time needed by the second processing system to the first processing system.

Thus the information about the processing time needed by the first processing system and the information about the processing time needed by the second processing system can be efficiently given to the second and the first processing system, respectively.

Desirably, the substrate processing method further includes the steps of: making the first processing system inform the second processing system of a first process cycle time needed for processing one substrate by the third process, making the second processing system compare the first process cycle time received from the first processing system and a second process cycle time needed for processing one substrate by the second process, and making the second processing system select the longer one of the first and the second process cycle time to use the selected process cycle time as a time interval at which the substrates are carried sequentially to the first processing system.

Thus the second processing system can obtain the process cycle time needed by the first processing system and can determine the shortest necessary time interval at which the substrates are carried to the first processing system. Consequently, the stagnation of the flow of the substrates due to the different process cycle times and the reduction of yield due to the different PED times can be prevented. Since the substrate processing system does not need any additional hardware, such as an out buffer, cost and footprints can be reduced.

Desirably, the substrate processing method further includes the steps of: making the second processing system inform the first processing system of a second process cycle time needed for processing one substrate by the second process, making the first processing system compare the second process cycle time and a first process cycle time needed for processing one substrate by the third process, and making the first processing system select the longer one of the first and the second process cycle time to use the selected process cycle time as a time interval at which substrates are carried sequentially from the first processing system to the second processing system.

Thus the first processing system obtains the process cycle time needed by the second processing system and can set a shortest necessary time interval at which substrates are carried to the second processing system. Consequently, the stagnation of the flow of the substrates due to the different process cycle times and the reduction of yield due to the different PED times can be prevented. Since the substrate processing system does not need any additional hardware, such as an out buffer, cost and footprints can be reduced.

The substrate processing system including the first and the second processing system and the substrate processing method according to the present invention are capable of processing a plurality of substrates by a single-wafer processing method by the cooperative operations of the first and the second processing system, of restricting the increase of cost and footprints and the reduction of yield and throughput.

### BRIEF DESCRIPTION OF THE DRAWINGS

Fig. 1 is a perspective view of a pattern forming system, namely, a substrate processing system, in a preferred embodiment according to the present invention;
Fig. 2 is a diagrammatic view showing sequential steps of a process to be carried out by the pattern forming system shown in Fig. 1;
Fig. 3 is a block diagram of the pattern forming system shown in Fig. 1 and a host computer for controlling the pattern forming system;
Fig. 4 is a block diagram of control systems included in a resist film forming and developing system and an exposure system;
Fig. 5 is a flow chart of a carrying operation control procedure for controlling carrying wafers between a resist film forming and developing system and a exposure system to process different process jobs by different processes of different process conditions sequentially;
Fig. 6 is a flow chart of another carrying operation control procedure for controlling carrying wafers between a resist film forming and developing system and a exposure system to process different process jobs by different processes of different process conditions sequentially;
Fig. 7 is a flow chart of a carrying operation control procedure for controlling carrying wafers between the resist film forming and developing system and the exposure system to process the wafers sequentially under the same process conditions;
Fig. 8 is a flow chart of another carrying operation control procedure for controlling carrying wafers between the resist film forming and developing system and the exposure system to process a process job;
Fig. 9 is a block diagram of a known in-line processing system including a resist film forming and developing system and an exposure system;
Fig. 10 is a flow chart of a known carrying operation control procedure for controlling carrying wafers between the resist film forming and developing system and the exposure system to process different process jobs by processes of different process conditions sequentially; and
Fig. 11 is a flow chart of another known carrying operation control procedure for controlling carrying wafers between the resist film forming and developing system and the exposure system to process different process jobs by processes of different process conditions sequentially.

### DESCRIPTION OF THE PREFERRED EMBODIMENTS

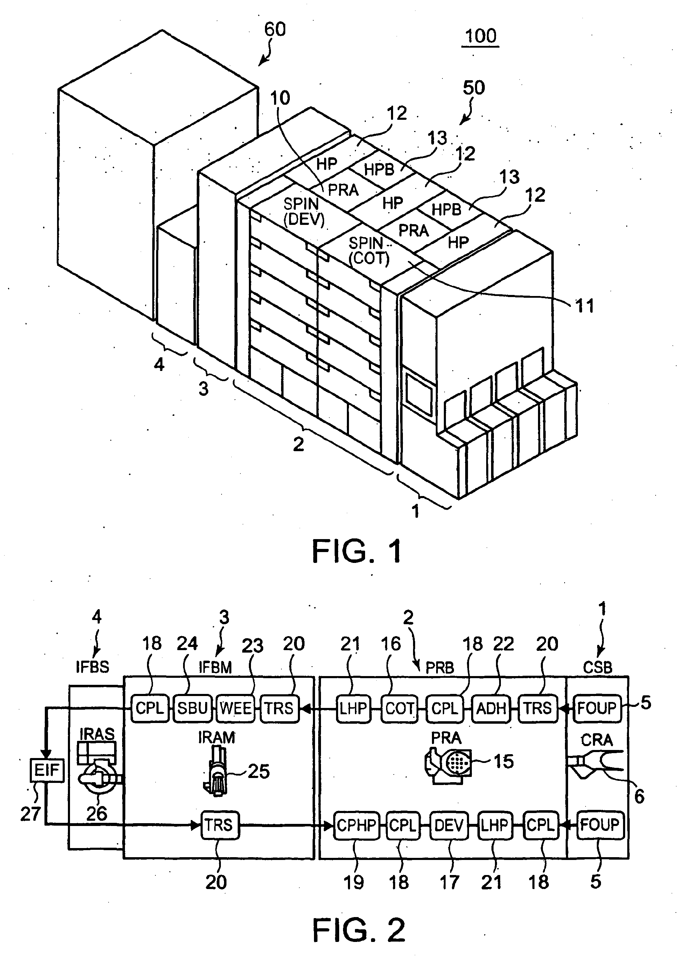

A substrate processing system and a substrate processing methods of the present invention will be described in terms of preferred embodiments thereof shown in the accompanying drawings. Fig. 1 is a perspective view of a pattern forming system 100, namely, a substrate processing system, in a preferred embodiment according to the present invention and Fig. 2 is a diagrammatic view showing sequential steps of a process to be carried out by the pattern forming system shown in Fig. 1.

The pattern forming system 100 shown in Fig. 1 is used in a photolithographic process in an electronic device manufacturing process for manufacturing electronic devices, such as semiconductor devices or liquid crystal displays. The pattern forming system 100 includes a resist film forming and developing system (first processing system) 50 and an exposure system (second processing system) 60. The resist film forming and developing system 50 and the exposure system 60 are connected to carry out operations in an in-line processing mode.

The resist film forming and developing system 50 includes a carrier station block (CSB) 1, a processing block (PRB) 2, a main interface block (IFBM) 3 and a sub interface block (IFBS) 4.

A plurality of carrier cassettes (FOUPs) 5 each hermetically containing a plurality of wafers are delivered to and sent out from the carrier station block (CSB) 1. The carrier station block 1 is provided with a carrier station carrying arm (CRA) 6 for handling the carrier cassettes 5. The processing block (PRB) 2 includes a PRA tower 10, a SPIN tower 11, a connecting oven (HP) tower 12 and a back oven (HPB) tower 13 respectively for different processes. Each of the towers is built by vertically stacking processing modules for processing wafers.

The PRA tower 10 is provided with a process block carrying arm (PRA) 15 as shown in Fig. 2. The carrying arm 15 can move vertically and can turn about a vertical axis. The carrying arm 15 transfers a wafer to and receives a wafer from each of the processing modules around the carrying arm 15.

The SPIN tower 11 is built by stacking up coating process stations (COT) 16 for coating a surface of a wafer with a resist and developing process stations (DEV) 17 for processing a wafer by a developing process in layers, such as five layers.

The connecting oven (HP) tower 12 is built by stacking up, for example, a chill plate process station (CPL) 18, a chilling precision hot plate process station (CPHP) 19, and a transition stage (TRS) 20 in layers. The back oven (HPB) tower 13 is built by stacking up low-temperature hot plate process stations (LHP) 21 for carrying out a low-temperature thermal treatment and adhesion process stations (ADH) 22 for carrying out a hydrophobic property imparting process in layers.

The main interface block (IFBM) is built by stacking up peripheral exposure process stations (WEE) 23, stationary buffering states (SBU) 24 and main interface block carrying arms (IRAM) 25 shown in Fig. 2 in layers. Each of the main carrying arms (IRAM) 25 can move vertically and can turn about a vertical axis. The main carrying arm carries a wafer to and receives a wafer from each of the processing modules around the main carrying arm 15.

The sub interface block (IFBS) 4 is provided with a sub interface block carrying arm (IRAS) 26 as shown in Fig. 2. The sub interface block carrying arm (IRAS) 26 carries a wafer between the resist film forming and developing system 50 and an exposure system interface (EIF) 27 included in the exposure system 60.

The exposure system 60 irradiates a wafer having a surface coated with a resist film through a reticle having a circuit pattern with a laser beam for exposure. The exposure system 60 is provided with an exposure system interface (EIF) 27, namely, a wafer carrying device. The exposure system 60 receives a wafer from and sends a wafer to the resist film forming and developing system 50 through the exposure system interface (EIF) 27.

A series of processes to be carried out by the pattern forming system 100 will be described with reference to Fig. 2.

The carrier station carrying arm (CRA) 6 carries a carrier cassette(FOUP) 5 containing unprocessed wafers into the carrier station block (CSB) 1. A carrying mechanism, not shown, carries one of the wafers contained in the carrier cassette 5 to the transition stage (TRS) 20. Then, after the wafer has been aligned, the carrying arm (PRA) 15 carries the wafer to the adhesion process station (ADH) 22. The adhesion process station 22 processes the wafer by a hydrophobicity imparting process. Subsequently, the wafer is subjected to a predetermined cooling process at the chill plate process station (CPL). Then, the wafer is subjected to a resist film forming process at the coating process station (COT) 16 to form a resist film on a surface of the wafer.

The wafer is subjected to a predetermined heating process, namely, a prebaking process, at the low-temperature hot plate process station (LHP) 21. Then, the wafer is carried to the transition state (TRS) 20 of the main interface block (IFBM) 3. Then, the main interface block carrying arm (IRAM) 25 carries the wafer to the peripheral exposure process station (WEE) 23 to subject a peripheral part of the wafer to an exposure process. Then, the wafer is held temporarily on the stationary buffering stage (SBU) 24. Wafers thus temporarily held on the stationary buffering stage 24 are subjected sequentially to a cooling process at the chill plate process station (CPL).

The series of those processes executed by the resist film forming and developing system 50 will be referred to as a first process P1.

After the completion of the first process P1, the sub interface block carrying arm (IRAS) 26 carries the wafer through the sub interface block (IFBS) 4 to the exposure system 60 to subject the wafer to an exposure process.

The exposure process to be carried out by the exposure system 60 will be referred to as a second process P2.

The wafer processed by the second process P2, namely, the exposure process, is carried through the sub interface block (IFBS) 4 to the transition stage (TRS) 20 of the main interface block (IFBM). The chilling precision hot plate process station (CPHP) 19 processes the wafer by a predetermined heating process and the chill plate process station (CPL) 18 processes the wafer by a cooling process.

Subsequently, the wafer is carried to the developing process station (DEV) 17 and is subjected to a developing process. Then, the resist film is subjected to a heating process, namely, a postexposure baking process (PEB) at the low-temperature hot plate process station (LHP) 21. The postexposure baking process (PEB) heats the wafer to dry the resist film and to increase the adhesion of the resist film to the wafer. Then, the wafer is subjected to a cooling process at the chill plate process station (CPL). The wafer thus processed is returned to the carrier cassette (FOUP) 15.

A series of processes carried out by the resist film forming and developing system 50 after the completion of the exposure process will be referred to as a third process P3.

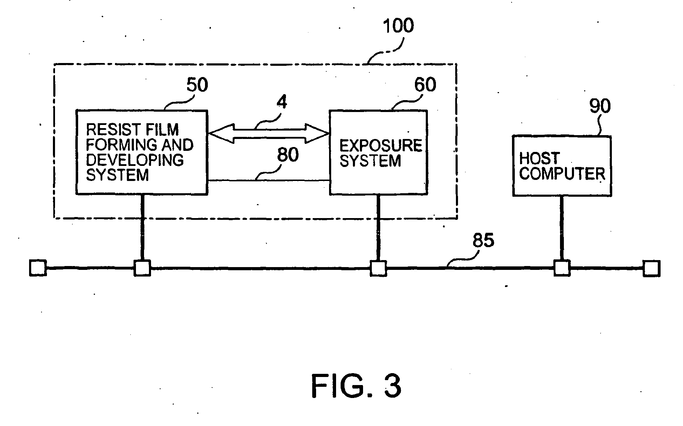

The control system of the pattern forming system 100 will be described. Fig. 3 shows the relation between the pattern forming system 100 and a host computer 90 for controlling the pattern forming system 100 in a block diagram. As shown in Fig. 3, the resist film forming and developing system 50 and the exposure system 60 of the pattern forming system 100 are disposed such that a wafer can be transferred between the resist film forming and developing system 50 and the exposure system 60 by the sub interface block (IFBS) 4. The resist film forming and developing system 50 and the exposure system 60 are connected by communication lines 80.

The resist film forming and developing system 50 and the exposure system 60 of the pattern forming system 100 are connected to a LAN cable 85 of a LAN (local area network)of the Ethernet® system. The host computer 90 is connected to the LAN cable 85.

The host computer 90 controls the operations of the pattern forming system 100 through the LAN. For example, the host computer 90 specifies a process recipe specifying processing conditions for the pattern forming system 100 and gives a processing start command to the pattern forming system 100.

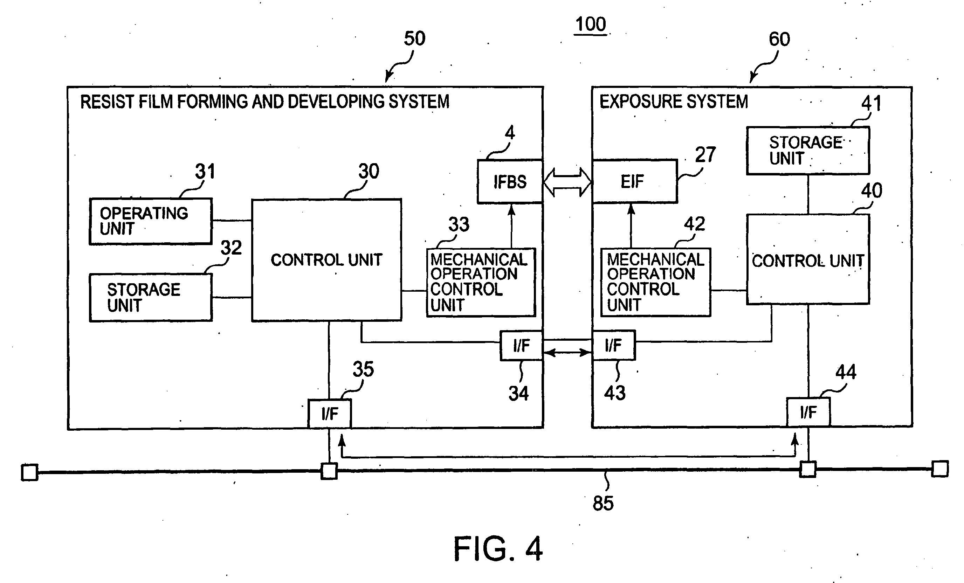

The internal control systems of the resist film forming and developing system 50 and the exposure system 60 will be described. Fig. 4 is a block diagram of control systems included in the resist film forming and developing system 50 and the exposure system 60.

Referring to Fig. 4, the resist film forming and developing system 50 includes a control unit 30 (first control means) for controlling operations of the components of the resist film forming and developing system 50, an operating unit 31 to be operated by an operator, a storage unit 32 for storing information, a mechanical operation control unit 33 for controlling mechanical operations of the carrying arm and such and communication interfaces (first communication means) 34 and 35 connected respectively to external devices. As shown in Fig. 4, the sub interface block carrying arm (IRAS) 26 of the interface block station 4 is connected to the mechanical operation control unit 33.

The exposure system 60, similarly to the resist film forming and developing system 50, includes a control unit (second control means) 40, a storage unit 41, a mechanical operation control unit 42 and communication interfaces (second communication means) 43 and 44. As shown in Fig. 4, the exposure system interface (EIF) 27 is connected to the mechanical operation control unit 42.

The storage unit 32 of the resist film forming and developing system 50 stores a group of process recipes specifying different process conditions for processing wafers. For example, the operator can select a desired one of the process recipes by entering an identification code indicating the desired process recipe by operating the operating unit 31. The control unit 30 reads the process recipe from the storage unit 32 and holds the process recipe temporarily. The control unit 30 makes the mechanical operation control unit 33 perform control operations according to the process recipe. The process recipes are resist film forming and developing recipes, i.e., programs as pieces of software. The hot computer 90 may give a process recipe to be executed through the communication interface 35 to the control unit 30.

The storage unit 41 of the exposure system 60 stores a plurality of exposure recipes respectively specifying different exposure conditions. When the host computer 90 gives an identification code indicating an exposure recipe through the communication interface 41 to the control unit 40, the control unit 40 reads the exposure recipe indicated by the identification code from the storage unit 41 and executes the exposure recipe. The exposure recipe specifies, for example, a reticle, an exposure time, an exposure and such.

A timing signal for timing transferring a wafer from the resist film forming and developing system 50 to the exposure system 60 and a timing signal for timing transferring a wafer from the exposure system 60 to the resist film forming and developing system 50 are given to the resist film forming and developing system 50 and the exposure system 60 through the communication interfaces 34 and 43 and the communication lines 80. The control unit 30 determines a wafer carrying time interval at which wafers are carried from the resist film forming and developing system 50 to the exposure system 60 in processing a process job (PJ) and a wafer carrying time interval between two successive, different process jobs (PJs)

The control units 30 of the resist film forming and developing system 50 receives information about processes being carried out by the exposure system 60 and the control unit 40 of the exposure system 60 receives information about processes executed by the resist film forming and developing system 60 through the communication lines 80.

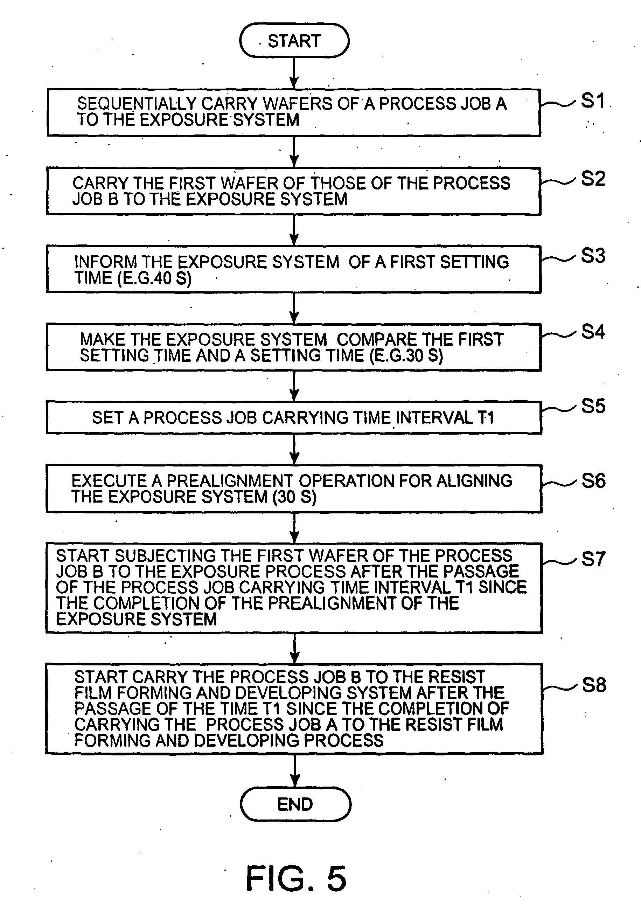

A method of controlling carrying a wafer between the resist film forming and developing system 50 and the exposure system 60 of the pattern forming system 100 having the foregoing control system will be described in connection with flow charts shown in Figs. 5 to 8.

Fig. 5 is a flow chart of a carrying operation control procedure for controlling carrying wafers between the resist film forming and developing system 50 and the exposure system 60 to process a process job A (first substrate group) and a process job B (second substrate group) by different processes of different process conditions sequentially.

The carrying operation control procedure shown in Fig. 5 will be described. In step S1, the wafers of the process job A prebaked by the first process P1 are carried sequentially from the resist film forming and developing system 50 to the exposure system 60.

In step S2, the resist film forming and developing system 50 carries the first wafer of those of the process job B to the exposure system 50 after all the wafers of the process job A have been carried to the exposure system 50.

In step S3, the control unit 30 of the resist film forming and developing system 50 informs the control unit 40 of the exposure system 50 of a PEB temperature setting time (first setting time) of, for example 40 s, namely, a time needed to set a postexposure baking temperature, for the postexposure baking (PEB) of the wafers of the process job B by the third process P3.

In step S4, the control unit 40 of the exposure system 60 compares the PEB temperature setting time received from the control unit 30 of the resist film forming and developing system 50 and a setting time of, for example, 30 s needed for setting conditions for processing wafers by the second process P2 to be carried out by the exposure system 60, namely, a time needed to align the exposure system 60.

In step S5, the control unit 40 of the exposure system 60 selects the longer one of the setting times to use the selected setting time as a process job carrying time interval T1, i.e., a time interval between the end of carrying the process job A to the resist film forming and developing system 50 and the start of carrying the process job B to the resist film forming and developing system 50. In this embodiment, the PEB temperature setting time is the process job carrying time interval T1.

In step S6, the exposure system 60 completes a prealignment operation for aligning the exposure system 60 to process the process job B in, for example, 30 s after completing an exposure process for the process job A.

In step S7, the control unit 40 of the exposure system 60 defers starting the exposure process for exposing the process job B for a time of 10 s equal to the remainder of the subtraction of the alignment time of 30 s from the process job carrying time interval T1 of 40 s after the completion of the prealignment of the exposure system.

Thus the time interval between the end of processing the last wafer of the process job A and the start of processing the first wafer of the process job B is equal to the process job carrying time interval T1 of 40 s. In step S8, the first wafer of the process job B is carried from the exposure system 60 to the resist film forming and developing system 50 after the passage of the process job carrying time interval T1 since the end of carrying the process job A from the exposure system 60 to the resist film forming and developing system 50.

Thus the time interval between the end of processing the process job A and the start of processing the process job B is 40 s shorter than 70 s need by the conventional pattern forming system. Consequently, the in-line pattern forming system 100 processes wafers at a high throughput.

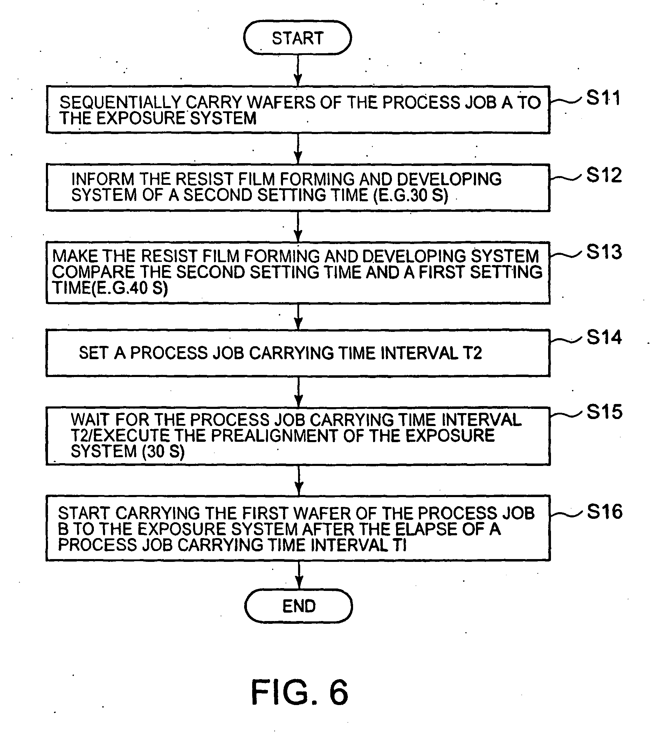

The process job A and the process job B, which are processed by processes of different process conditions, respectively, may be processed by a carrying operation control procedure shown in Fig. 6.

The carrying operation control procedure shown in Fig. 6 will be described.

In step S11, the wafers of the process job A prebaked by the first process P1 are carried sequentially from the resist film forming and developing system 50 to the exposure system 60.

In step S12, the control unit 40 of the exposure system 60 informs the control unit 30 of the resist film forming and developing system 50 a prealignment time of, for example 30 s, i.e., a setting time (second setting time) needed to set the exposure system 60 for the second process P2 before the completion of carrying all the wafers of the process job A to the exposure system 60.

In step S13, the control unit 30 of the resist film forming and developing system 50 compares the prealignment time of 30 s received from the control unit 40 of the exposure system 60 and a PEB temperature setting time of, for example 40 s needed to set conditions for processing the wafers of the process job B by postexposure baking (PEB) in the third process P3.

In step S14, the control unit 30 of the resist film forming and developing system 50 selects the longer one of the prealignment time and the PEB temperature setting time to use the selected longer time as a process job carrying time interval T2, i.e., a time interval between the end of carrying the process job A to the exposure system 60 and the start of carrying the process job B to the exposure system 60. In this embodiment, the PEB temperature setting time is the process job carrying time interval T2.

The resist film forming and developing system 50 defers starting carrying the wafers of the process job B to the exposure system 60 for the process job carrying time interval T2 of 40 s after the completion of carrying the wafers of the process job A to the exposure system 60.

In step S15, the exposure system 60 completes a prealignment operation for aligning the exposure system 60 to process the process job B in, for example, 30 s after completing an exposure process for the process job A.

In step S16, the resist film forming and developing system 50 carries the first wafer of the process job B to the exposure system 60 after the elapse of the wafer carrying time interval T2. A time interval between the end of exposure of the last wafer of the process job A and the start of exposure of the first wafer of the process job B is equal to the wafer carrying time interval T2 of 40 s

When operations for carrying the wafers of the process jobs A and B are controlled by the carrying operation control procedure shown in Fig. 6, the processing time interval between the end of processing the wafers of the process job A and the start of processing the wafers of the process job B is 40 s, which is equal to the time needed when operations for carrying the wafers of the process jobs A and B are controlled by the carrying operation control procedure shown in Fig. 5 and shorter than 70 s need by the conventional pattern forming system. Consequently, the in-line pattern forming system 100 processes wafers at a high throughput.

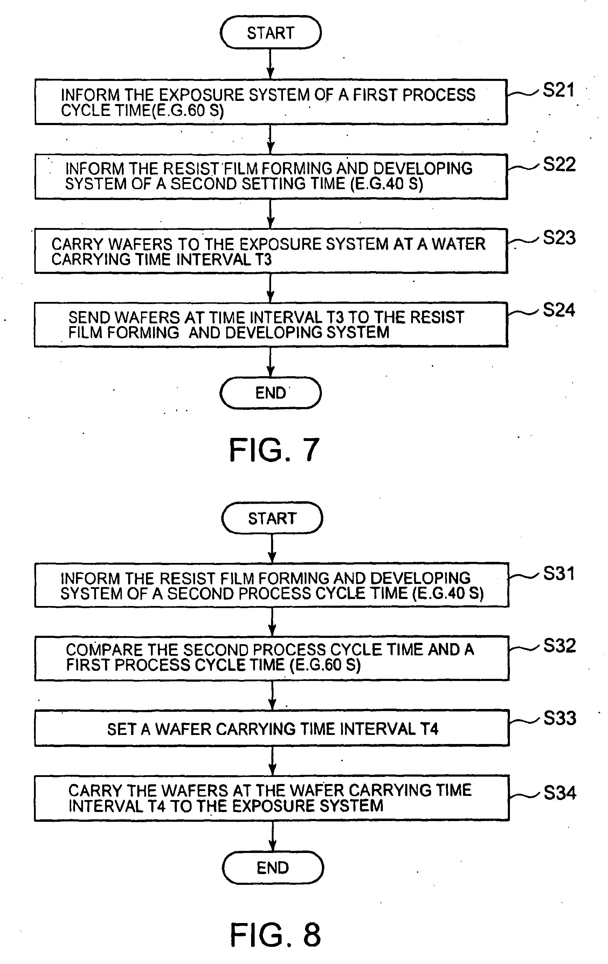

Fig. 7 is a flow chart of a carrying operation control procedure for controlling carrying wafers between the resist film forming and developing system 50 and the exposure system 60 to process the wafers sequentially under the same process conditions. The carrying operation control procedure shown in Fig. 7 will be described.

In step S21, the control unit 30 of the resist film forming and developing system 50 informs the control unit 40 of the exposure system 60 of a first process cycle time of, for example, 60 s needed by the resist film forming and developing system 50 to process one wafer by postexposure baking (PEB) in the third process P3.

In step S22, the control unit 40 of the exposure system 60 compares the first cycle time received from the control unit 30 of the resist film forming and developing system 50 and a second process cycle time of, for example, 40 s needed by the exposure system 60 to process one wafer.

In step S23, the exposure system 60 selects the longer one of the process cycle times to use the longer process cycle time as a wafer carrying time interval T3 at which wafers are carried from the exposure system 60 to the resist film forming and developing system 50. In this embodiment, the first process cycle time of 60 s is the wafer carrying time interval T3.

In step S24, the exposure system 60 sends out the exposed wafers at time intervals equal to the wafer carrying time interval T3 to the resist film forming and developing system 50. In this embodiment, the wafers are carried to the resist film forming and developing system 50 at intervals of 60 s.

The carrying operation control procedure shown in Fig. 7 carries the wafers from the exposure system 60 to the resist film forming and developing system 50 at time intervals equal to the longer cycle time and hence the stagnation of flow of the wafers before postexposure baking can be suppressed.

Carrying operations for carrying wafers to be sequentially processed under the same process conditions may be controlled by a carrying operation control procedure shown in Fig. 8. The carrying operation control procedure shown in Fig. 8 will be described.

In step S31, the control unit 40 of the exposure system 60 informs the control unit 30 of the resist film forming and developing system 50 of the second process cycle time of, for example, 40 s needed by the exposure system 60 to process one wafer.

In step S32, the control unit 30 of the resist film forming and developing system 50 compares the second process cycle time and a first process cycle time of, for example, 60 s needed by the resist film forming and developing system 50 to process one wafer by postexposure baking (PEB) in the third process P3.

In step S33, the control unit 30 of the resist film forming and developing system 50 selects the longer one of the first and the second process cycle time to use the longer process cycle time as a wafer carrying time interval T4 at which the wafers are carried from the resist film forming and developing system 50 to the exposure system 60. In this embodiment, the first process cycle time of 60 s is the wafer carrying time interval T4.

In step S34, the resist film forming and developing system 50 sends the wafers processed by prebaking in the first process P1 at time intervals equal t the wafer carrying time interval T4 of 60 s. Thus the stagnation of flow of the wafers before postexposure baking can be suppressed.

As apparent from the foregoing description, according to the present invention, when the wafers of the process job A and those of the process job B are to be processed sequentially by processes of different process conditions, respectively, by the resist film forming and developing system 50 and the exposure system 60, the resist film forming and developing system 50 (the exposure system 60) obtains information about processing time needed by the exposure system 60 (the resist film forming and developing system 50) and a shortest necessary wafer processing time interval can be determined. Thus waiting times determined individually by the resist film forming and developing and the exposure system of the conventional pattern forming system can be eliminated. Consequently, the operation of only the resist film forming and developing system 50 or the exposure system 60 is interrupted for the shortest necessary time and the in-line pattern forming system 100 can processes wafers at a high throughput.

When the process cycle time needed by the exposure system 50 to achieve the second process P2 and the process cycle time needed by the resist film forming and developing system 50 to achieve the third process P3 are different from each other, the wafers are carried from the exposure system 60 to the resist film forming and developing system 50 at time intervals equal to the longer process cycle time

Thus the stagnation of flow of the wafers in the resist film forming and developing system 50 after the exposure process can be suppressed. Thus any piece of hardware, such as an out buffer, is unnecessary, steps of operation of the carrying arm are not increased, and hence the increase of the cost and footprints and the reduction of the through put of the in-line process can be restricted.

The time needed before starting the postexposure baking process (PEB process), namely, the postexposure delay time (PED time) can be fixed and the resist film formed on the wafers undergo the acid reaction and the reduction of yield can be restricted.

Although the resist film forming and developing system 50 and the exposure system 60 exchange information about processing time in the foregoing embodiments, the host computer (the general control means) 90 may inform the respective control units 30 and 40 of the resist film forming and developing system 50 and the exposure system 60 of information about processing time.

The respective control units 30 and 40 of the resist film forming and developing system 50 and the exposure system 60 can determine the wafer carrying time intervals T1 to T4 on the basis of the information received from the host computer 90.

Workpieces to be processed by the substrate processing system of the present invention are not limited to wafers and may be LCD substrates, CD substrates, glass substrates, photomasks or printed wiring boards.

The present invention is applicable to resist pattern forming systems for processing substrates, such as semiconductor wafers, and can be suitably applied to the semiconductor device manufacturing industry and the electronic device manufacturing industry.

## Claims

1. A substrate processing system comprising:
a first processing system (50) for carrying out a first process and a third process; and
a second processing system (60) for carrying out a second process after the first processing system (50) has completed the first process and before the first processing system (50) carries out a third process;
wherein
the first processing system (50) includes a first control means (30) for controlling a substrate carrying operation and a first communication means (34) for communication with an external system,
the second processing system (60) includes a second control means (40) for controlling a substrate carrying operation and a second communication means (43, 44) for communication with the external system, and
the first control means (30) is configured to receive information about processing time for the second processing system (60) through the first communication means (34) and to control a substrate carrying operation between the first (50) and the second processing system (60) on the basis of the received information,
**characterized in that**
the second control means (40) is configured to inform the first control means (30) of a second setting time for setting conditions for processing substrates of a second group by the second process,
the first control means (30) is further configured to compare the second setting time received from the second control means (40) and a first setting time for setting conditions for processing the substrates of the second group by the third process, and
the first control means (30) is configured to select the longer one of the first and the second setting time to use the selected setting time as a time interval between the completion of carrying substrates of a first group to the second processing system (60) and the start of carrying the substrates of the second group to the second processing system (60),
or
the second control means (40) is configured to receive information about processing time for the first processing system (50) through the second communication means (43, 44) and to control a substrate carrying operation between the first (50) and the second processing system (60) on the basis of the received information,
**characterized in that**
the first control means (30) is configured to inform the second control means (40) of a first setting time for setting conditions for processing the substrates of the second group by the third process,
the second control means (40) is further configured to compare the first setting time received from the first control means (30) and a second setting time for setting conditions for processing the substrates of the second group by the second process, and
the second control means (40) is further configured to select the longer one of the first and the second setting time to use the selected setting time as a time interval between the completion of sending out the substrates of the first group and the start of sending out the substrates of the second group

2. The substrate processing system according to claim 1 further comprising a general control means (90) for controlling operations of the first (50) and the second processing system (60),
wherein the general control means (90) is configured to give the information about the processing time for the first processing system (50) through the second communication means (43, 44) to the second control means of the second processing system (60) or to give the information about the processing time for the second processing system (60) through the first communication means (34) to the first control means of the first processing system (50).

3. The substrate processing system according to claim 1, wherein
the first control means (30) is configured to inform the second control means (40) of a first process cycle time for processing one substrate by the third process,
the second control means (40) is configure to compare the first process cycle time received from the first control means (30) and a second process cycle time for processing one substrate by the second process, and
the second control means (40) is configured to select the longer one of the first and the second process cycle time to use the selected process cycle time as a time interval at which the substrates are carried sequentially from the second processing system (60) to the first processing system (50).

4. The substrate processing system according to claim 1, wherein
the second control means (40) is configured to inform the first control means (30) of a second process cycle time for processing one substrate by the second process,
the first control means (30) is configured to compare the second process cycle time received from the second control means (40) and a first process cycle time for processing one substrate by the third process, and
the first control means (30) is configured to select the longer one of the first and the second process cycle time to use the selected process cycle time as a time interval at which substrates are carried sequentially from the first processing system (50) to the second processing system (60).

5. A substrate processing method to be carried out by a substrate processing system, for processing a plurality of substrates by a single-wafer processing method, including a first processing system (50) for carrying out a first process and a third process; and a second processing system (60) for carrying out a second process after the first processing system (50) has completed the first process and before the first processing system (50) carries out the third process; said substrate processing method comprising the steps of:
making the first processing system (50) obtain information about processing time for the second processing system (60) through a communicating means or making the second processing system (60) obtain information about processing time for the first processing system (50) through a communicating means; and
controlling a carrying operation for carrying the substrate between the first (50) and the second processing system (60) on the basis of the obtained information,
**characterized by** further comprising, when substrates of a first group and those of a second group are to be sequentially processed by different processes specified by different processing conditions, respectively, the steps of:
making the first processing system (50) inform the second processing system (60) of a first setting time for setting conditions for processing the substrates of the second group by the third process,
making the second processing system (60) compare the first setting time received from the first processing system (50) and a second setting time for setting conditions for processing the substrates of the second group by the second process, and
making the second processing system (60) select the longer one of the first and the second setting time to use the selected setting time as a time interval between the completion of sending out the substrates of the first group to the second processing system (60) and the start of sending out the substrates of the second group to the second processing system (60),
or the steps of:
making the second processing system (60) inform the first processing system (50) of a second setting time for setting conditions for processing the substrates of the second group by the second process,
making the first processing system (50) compare the second setting time and a first setting time for setting conditions for processing the substrates of the second group by the third process, and
making the first processing system (50) select the longer one of the first and the second setting time to use the selected setting time as a time interval between the completion of carrying the substrates of the first group and the start of carrying the substrates of the second group.

6. The substrate processing method according to claim 5, wherein a general control means for controlling operations of the first (50) and the second processing system (60) gives the information about the processing time for the first processing system (50) to the second processing system (60) or gives the information about the processing time for the second processing system (60) to the first processing system (50).

7. The substrate processing method according to claim 5 further comprising the steps of:
making the first processing system (50) inform the second processing system (60) of a first process cycle time for processing one substrate by the third process,
making the second processing system (60) compare the first process cycle time received from the first processing system (50) and a second process cycle time for processing one substrate by the second process, and
making the second processing system (60) select the longer one of the first and the second process cycle time to use the selected process cycle time as a time interval at which the substrates are carried sequentially to the first processing system (50).

8. The substrate processing method according to claim 5 further comprising the steps of:
making the second processing system (60) inform the first processing system (50) of a second process cycle time for processing one substrate by the second process,
making the first processing system (50) compare the second process cycle time and a first process cycle time for processing one substrate by the third process, and
making the first processing system (50) select the longer one of the first and the second process cycle time to use the selected process cycle time as a time interval at which substrates are carried sequentially from the first processing system (50) to the second processing system (60).

## Patentansprüche

1. Ein Substratverarbeitungssystem, umfassend:
ein erstes Verarbeitungssystem (50) zum Ausführen eines ersten Prozesses und eines dritten Prozesses; und
ein zweites Verarbeitungssystem (60) zum Ausführen eines zweiten Prozesses, nachdem das erste Verarbeitungssystem (50) den ersten Prozess abgeschlossen hat und bevor das erste Verarbeitungssystem (50) einen dritten Prozess ausführt;
wobei
das erste Verarbeitungssystem (50) ein erstes Steuermittel (30) zum Steuern einer Substratübertragungsoperation und ein erstes Kommunikationsmittel (34) für eine Kommunikation mit einem externen System enthält,
das zweite Verarbeitungssystem (60) ein zweites Steuermittel (40) zum Steuern einer Substratübertragungsoperation und ein zweites Kommunikationsmittel (43, 44) für eine Kommunikation mit dem externen System enthält, und
das erste Steuermittel (30) konfiguriert ist, Information über eine Verarbeitungszeit für das zweite Verarbeitungssystem (60) durch das erste Kommunikationsmittel (34) zu empfangen und eine Substratübertragungsoperation zwischen dem ersten (50) und dem zweiten Verarbeitungssystem (60) auf der Basis der empfangenen Information zu steuern,
**gekennzeichnet dadurch, dass**
das zweite Steuermittel (40) konfiguriert ist, das erste Steuermittel (30) über eine zweite Einstellzeit zum Einstellen von Bedingungen für Verarbeitung von Substraten einer zweiten Gruppe durch den zweiten Prozess zu informieren,
das erste Steuermittel (30) weiter konfiguriert ist, die zweite Einstellzeit, die von dem zweiten Steuermittel (40) empfangen wird, und eine erste Einstellzeit zum Einstellen von Bedingungen für eine Verarbeitung der Substrate der zweiten Gruppe durch den dritten Prozess zu vergleichen, und
das erste Steuermittel (30) konfiguriert ist, die längere der ersten und der zweiten Einstellzeit auszuwählen, um die ausgewählte Einstellzeit als ein Zeitintervall zwischen dem Abschluss einer Übertragung von Substraten einer ersten Gruppe zu dem zweiten Verarbeitungssystem (60) und dem Start einer Übertragung der Substrate der zweiten Gruppe zu dem zweiten Verarbeitungssystem (60) zu verwenden,
oder
das zweite Steuermittel (40) konfiguriert ist, Information über eine Verarbeitungszeit für das erste Verarbeitungssystem (50) durch das zweite Kommunikationsmittel (43, 44) zu empfangen und eine Substratübertragungsoperation zwischen dem ersten (50) und dem zweiten Verarbeitungssystem (60) auf der Basis der empfangenen Information zu steuern,
**gekennzeichnet dadurch, dass**
das erste Steuermittel (30) konfiguriert ist, das zweite Steuermittel (40) über eine erste Einstellzeit zum Einstellen von Bedingungen für eine Verarbeitung der Substrate der zweiten Gruppe durch den dritten Prozess zu informieren,
das zweite Steuermittel (40) weiter konfiguriert ist, die erste Einstellzeit, die von dem ersten Steuermittel (30) empfangen wird, und eine zweite Einstellzeit zum Einstellen von Bedingungen für eine Verarbeitung der Substrate der zweiten Gruppe durch den zweiten Prozess zu vergleichen, und
das zweite Steuermittel (40) weiter konfiguriert ist, die längere der ersten und der zweiten Einstellzeit auszuwählen, um die ausgewählte Einstellzeit als ein Zeitintervall zwischen dem Abschluss des Aussendens der Substrate der ersten Gruppe und dem Start des Aussendens der Substrate der zweiten Gruppe zu verwenden.

2. Das Substratverarbeitungssystem nach Anspruch 1, ferner umfassend ein allgemeines Steuermittel (90) zum Steuern von Operationen des ersten (50) und des zweiten Verarbeitungssystems (60),
wobei das allgemeine Steuermittel (90) konfiguriert ist, die Information über die Verarbeitungszeit für das erste Verarbeitungssystem (50) durch das zweite Kommunikationsmittel (43, 44) zu dem zweiten Steuermittel des zweiten Verarbeitungssystems (60) zu geben oder die Information über die Verarbeitungszeit für das zweite Verarbeitungssystem (60) durch das erste Kommunikationsmittel (34) zu dem ersten Steuermittel des ersten Verarbeitungssystems (50) zu geben.

3. Das Substratverarbeitungssystem nach Anspruch 1, wobei
das erste Steuermittel (30) konfiguriert ist, das zweite Steuermittel (40) über eine erste Prozesszykluszeit zum Verarbeiten eines Substrats durch den dritten Prozess zu informieren,
das zweite Steuermittel (40) konfiguriert ist, die erste Prozesszykluszeit, die von dem ersten Steuermittel (30) empfangen wird, und eine zweite Prozesszykluszeit zum Verarbeiten eines Substrats durch den zweiten Prozess zu vergleichen, und
das zweite Steuermittel (40) konfiguriert ist, die längere der ersten und der zweiten Prozesszykluszeit auszuwählen, um die ausgewählte Prozesszykluszeit als ein Zeitintervall zu verwenden, in dem die Substrate von dem zweiten Verarbeitungssystem (60) zu dem ersten Verarbeitungssystem (50) sequenziell übertragen werden.

4. Das Substratverarbeitungssystem nach Anspruch 1, wobei
das zweite Steuermittel (40) konfiguriert ist, das erste Steuermittel (30) über eine zweite Prozesszykluszeit zum Verarbeiten eines Substrats durch den zweiten Prozess zu informieren,
das erste Steuermittel (30) konfiguriert ist, die zweite Prozesszykluszeit, die von dem zweiten Steuermittel (40) empfangen wird, und eine erste Prozesszykluszeit zum Verarbeiten eines Substrats durch den dritten Prozess zu vergleichen, und
das erste Steuermittel (30) konfiguriert ist, die längere der ersten und der zweiten Prozesszykluszeit auszuwählen, um die ausgewählte Prozesszykluszeit als ein Zeitintervall zu verwenden, in dem Substrate von dem ersten Verarbeitungssystem (50) zu dem zweiten Verarbeitungssystem (60) sequenziell übertragen werden.

5. Ein Substratverarbeitungsverfahren, das durch ein Substratverarbeitungssystem auszuführen ist, zum Verarbeiten einer Vielzahl von Substraten durch ein Einzelwafer-Verarbeitungsverfahren, enthaltend ein erstes Verarbeitungssystem (50) zum Ausführen eines ersten Prozesses und eines dritten Prozesses; und ein zweites Verarbeitungssystem (60) zum Ausführen eines zweiten Prozesses, nachdem das erste Verarbeitungssystem (50) den ersten Prozess abgeschlossen hat und bevor das erste Verarbeitungssystem (50) den dritten Prozess ausführt; das Substratverarbeitungsverfahren die Schritte umfassend zum:
Herstellen des ersten Verarbeitungssystems (50), Information über eine Verarbeitungszeit für das zweite Verarbeitungssystem (60) durch ein Kommunikationsmittel zu erhalten, oder Herstellen des zweiten Verarbeitungssystems (60), Information über eine Verarbeitungszeit für das erste Verarbeitungssystem (50) durch ein Kommunikationsmittel zu erhalten; und
Steuern einer Übertragungsoperation zum Übertragen des Substrats zwischen dem ersten (50) und dem zweiten Verarbeitungssystem (60) auf der Basis der erhaltenen Information,
**gekennzeichnet dadurch**, wenn Substrate einer ersten Gruppe und jene einer zweiten Gruppe durch unterschiedliche Prozesse sequenziell zu verarbeiten sind, die jeweils durch unterschiedliche Verarbeitungsbedingungen spezifiziert sind, ferner die Schritte zu umfassen zum:
Herstellen des ersten Verarbeitungssystems (50), das zweite Verarbeitungssystem (60) über eine erste Einstellzeit zum Einstellen von Bedingungen zum Verarbeiten der Substrate der zweiten Gruppe durch den dritten Prozess zu informieren,
Herstellen des zweiten Verarbeitungssystems (60), die erste Einstellzeit, die von dem ersten Verarbeitungssystem (50) empfangen wird, und eine zweite Einstellzeit zum Einstellen von Bedingungen für eine Verarbeitung der Substrate der zweiten Gruppe durch den zweiten Prozess zu vergleichen, und
Herstellen des zweiten Verarbeitungssystems (60), die längere der ersten und der zweiten Einstellzeit auszuwählen, um die ausgewählte Einstellzeit als ein Zeitintervall zwischen dem Abschluss des Aussendens der Substrate der ersten Gruppe zu dem zweiten Verarbeitungssystem (60) und dem Start des Aussendens der Substrate der zweiten Gruppe zu dem zweiten Verarbeitungssystem (60) zu verwenden,
oder die Schritte zum:
Herstellen des zweiten Verarbeitungssystems (60), das erste Verarbeitungssystem (50) über eine zweite Einstellzeit zum Einstellen von Bedingungen für eine Verarbeitung der Substrate der zweiten Gruppe durch den zweiten Prozess zu informieren,
Herstellen des ersten Verarbeitungssystems (50), die zweite Einstellzeit und eine erste Einstellzeit zum Einstellen von Bedingungen für eine Verarbeitung der Substrate der zweiten Gruppe durch den dritten Prozess zu vergleichen, und
Herstellen des ersten Verarbeitungssystems (50), die längere der ersten und der zweiten Einstellzeit auszuwählen, um die ausgewählte Einstellzeit als ein Zeitintervall zwischen dem Abschluss des Übertragens der Substrate der ersten Gruppe und dem Start des Übertragens der Substrate der zweiten Gruppe zu verwenden.

6. Das Substratverarbeitungsverfahren nach Anspruch 5, wobei ein allgemeines Steuermittel zum Steuern von Operationen des ersten (50) und des zweiten Verarbeitungssystems (60) die Information über die Verarbeitungszeit für das erste Verarbeitungssystem (50) zu dem zweiten Verarbeitungssystem (60) gibt oder die Information über die Verarbeitungszeit für das zweite Verarbeitungssystem (60) zu dem ersten Verarbeitungssystem (50) gibt.

7. Das Substratverarbeitungssystem nach Anspruch 5, ferner umfassend die Schritte zum:
Herstellen des ersten Verarbeitungssystems (50), das zweite Verarbeitungssystem (60) über eine erste Prozesszykluszeit zum Verarbeiten eines Substrats durch den dritten Prozess zu informieren,
Herstellen des zweiten Verarbeitungssystems (60), die erste Prozesszykluszeit, die von dem ersten Verarbeitungssystem (50) empfangen wird, und eine zweite Prozesszykluszeit zum Verarbeiten eines Substrats durch den zweiten Prozess zu vergleichen, und
Herstellen des zweiten Verarbeitungssystems (60), die längere der ersten und der zweiten Prozesszykluszeit auszuwählen, um die ausgewählte Prozesszykluszeit als ein Zeitintervall zu verwenden, in dem die Substrate sequenziell zu dem ersten Verarbeitungssystem (50) übertragen werden.

8. Das Substratverarbeitungsverfahren nach Anspruch 5, ferner umfassend die Schritte zum:
Herstellen des zweiten Verarbeitungssystems (60), das erste Verarbeitungssystem (50) über eine zweite Prozesszykluszeit zum Verarbeiten eines Substrats durch den zweiten Prozess zu informieren,
Herstellen des ersten Verarbeitungssystems (50), die zweite Prozesszykluszeit und eine erste Prozesszykluszeit zum Verarbeiten eines Substrats durch den dritten Prozess zu vergleichen, und
Herstellen des ersten Verarbeitungssystems (50), die längere der ersten und der zweiten Prozesszykluszeit auszuwählen, um die ausgewählte Prozesszykluszeit als ein Zeitintervall zu verwenden, in dem Substrate von dem ersten Verarbeitungssystem (50) zu dem zweiten Verarbeitungssystem (60) sequenziell übertragen werden.

## Revendications

1. Système de traitement de substrat comprenant :
un premier système de traitement (50) pour exécuter un premier processus et un troisième processus ; et
un second système de traitement (60) pour exécuter un deuxième processus après que le premier système de traitement (50) a achevé le premier processus et avant que le premier système de traitement (50) n'exécute un troisième processus ;
dans lequel
le premier système de traitement (50) inclut un premier moyen de commande (30) pour commander une opération de transport de substrat et un premier moyen de communication (34) pour communiquer avec un système externe,
le second système de traitement (60) inclut un second moyen de commande (40) pour commander une opération de transport de substrat et un second moyen de communication (43, 44) pour communiquer avec le système externe, et
le premier moyen de commande (30) est configuré pour recevoir des informations concernant un temps de traitement pour le second système de traitement (60) par l'intermédiaire du premier moyen de communication (34) et pour commander une opération de transport de substrat entre le premier (50) et le second (60) système de traitement sur la base des informations reçues,
**caractérisé en ce que**
le second moyen de commande (40) est configuré pour informer le premier moyen de commande (30) d'un second temps de paramétrage pour paramétrer des conditions pour traiter des substrats d'un second groupe par le deuxième processus,
le premier moyen de commande (30) est de plus configuré pour comparer le second temps de paramétrage reçu en provenance du second moyen de commande (40) et un premier temps de paramétrage pour paramétrer des conditions pour traiter les substrats du second groupe par le troisième processus, et
le premier moyen de commande (30) est configuré pour sélectionner le plus long du premier et du second temps de paramétrage pour utiliser le temps de paramétrage sélectionné comme un intervalle de temps entre l'achèvement du transport des substrats d'un premier groupe vers le second système de traitement (60) et le début du transport des substrats du second groupe vers le second système de traitement (60),
ou
le second moyen de commande (40) est configuré pour recevoir des informations concernant un temps de traitement pour le premier système de traitement (50) par l'intermédiaire du second moyen de communication (43, 44) et pour commander une opération de transport de substrat entre le premier (50) et le second (60) système de traitement sur la base des informations reçues,
**caractérisé en ce que**
le premier moyen de commande (30) est configuré pour informer le second moyen de commande (40) d'un premier temps de paramétrage pour paramétrer des conditions pour traiter les substrats du second groupe par le troisième processus,
le second moyen de commande (40) est de plus configuré pour comparer le premier temps de paramétrage reçu en provenance du premier moyen de commande (30) et un second temps de paramétrage pour paramétrer des conditions pour traiter les substrats du second groupe par le deuxième processus, et
le second moyen de commande (40) est en outre configuré pour sélectionner le plus long du premier et du second temps de paramétrage pour utiliser le temps de paramétrage sélectionné comme un intervalle de temps entre l'achèvement de l'envoi des substrats du premier groupe et le début de l'envoi des substrats du second groupe.

2. Système de traitement de substrat selon la revendication 1, comprenant en outre un moyen de commande global (90) pour commander les fonctionnements du premier (50) et du second (60) système de traitement,
dans lequel le moyen de commande global (90) est configuré pour donner les informations concernant le temps de traitement pour le premier système de traitement (50) par l'intermédiaire du second moyen de communication (43, 44) au second moyen de commande du second système de traitement (60) ou pour donner les informations concernant le temps de traitement pour le second système de traitement (60) par l'intermédiaire du premier moyen de communication (34) au premier moyen de commande du premier système de traitement (50).

3. Système de traitement de substrat selon la revendication 1, dans lequel
le premier moyen de commande (30) est configuré pour informer le second moyen de commande (40) d'un premier temps de cycle de processus pour traiter un substrat par le troisième processus,
le second moyen de commande (40) est configuré pour comparer le premier temps de cycle de processus reçu en provenance du premier moyen de commande (30) et un second temps de cycle de processus pour traiter un substrat par le deuxième processus, et
le second moyen de commande (40) est configuré pour sélectionner le plus long du premier et du second temps de cycle de processus pour utiliser le temps de cycle de processus sélectionné comme un intervalle de temps auquel les substrats sont transportés de manière séquentielle du second système de traitement (60) au premier système de traitement (50).

4. Système de traitement de substrat selon la revendication 1, dans lequel
le second moyen de commande (40) est configuré pour informer le premier moyen de commande (30) d'un second temps de cycle de processus pour traiter un substrat par le deuxième processus,
le premier moyen de commande (30) est configuré pour comparer le second temps de cycle de processus reçu en provenance du second moyen de commande (40) et un premier temps de cycle de processus pour traiter un substrat par le troisième processus, et
le premier moyen de commande (30) est configuré pour sélectionner le plus long du premier et du second temps de cycle de processus pour utiliser le temps de cycle de processus sélectionné comme un intervalle de temps auquel les substrats sont transportés séquentiellement du premier système de traitement (50) au second système de traitement (60).

5. Procédé de traitement de substrat à exécuter par un système de traitement de substrat, pour traiter une pluralité de substrats par un procédé de traitement à plaquette unique, incluant un premier système de traitement (50) pour exécuter un premier processus et un troisième processus ; et un second système de traitement (60) pour exécuter un deuxième processus après que le premier système de traitement (50) a achevé le premier processus et avant que le premier système de traitement (50) n'exécute le troisième processus ; ledit procédé de traitement de substrat comprenant les étapes consistant à :
faire que le premier système de traitement (50) obtienne des informations concernant un temps de traitement pour le second système de traitement (60) par l'intermédiaire d'un moyen de communication ou faire que le second système de traitement (60) obtienne des informations concernant un temps pour le premier système de traitement (50) par l'intermédiaire d'un moyen de communication ; et
commander une opération de transport pour transporter le substrat entre le premier (50) et le second (60) système de traitement sur la base des informations obtenues,
**caractérisé** comme comprenant en outre, quand les substrats d'un premier groupe et ceux d'un second groupe doivent être traités séquentiellement par des processus, différents -respectivement spécifiés par des conditions de traitement différentes, les étapes consistant à :
faire que le premier système de traitement (50) informe le second système de traitement (60) d'un premier temps de paramétrage pour paramétrer des conditions pour traiter les substrats du second groupe par le troisième processus,
faire que le second système de traitement (60) compare le premier temps de paramétrage reçu en provenance du premier système de traitement (50) et un second temps de paramétrage pour paramétrer des conditions pour traiter les substrats du second groupe par le deuxième processus, et
faire que le second système de traitement (60) sélectionne le plus long du premier et du second temps de paramétrage pour utiliser le temps de paramétrage sélectionné comme un intervalle de temps entre l'achèvement de l'envoi des substrats du premier groupe au second système de traitement (60) et le début de l'envoi des substrats du second groupe au second système de traitement (60),
ou les étapes consistant à :
faire que le second système de traitement (60) informe le premier système de traitement (50) d'un second temps de paramétrage pour paramétrer des conditions pour traiter les substrats du second groupe par le deuxième processus,
faire que le premier système de traitement (50) compare le second temps de paramétrage et un premier temps de paramétrage pour paramétrer des conditions pour traiter les substrats du second groupe par le troisième processus, et
faire que le premier système de traitement (50) sélectionne le plus long du premier et du second temps de paramétrage pour utiliser le temps de paramétrage sélectionné comme un intervalle de temps entre l'achèvement du transport des substrats du premier groupe et le début du transport des substrats du second groupe.

6. Procédé de traitement de substrat selon la revendication 5, dans lequel un moyen de commande global pour commander des opérations du premier (50) et du second (60) système de traitement donne les informations concernant le temps de traitement pour le premier système de traitement (50) au second système de traitement (60) ou donne les informations concernant le temps de traitement pour le second système de traitement (60) au premier système de traitement (50).

7. Procédé de traitement de substrat selon la revendication 5, comprenant en outre les étapes consistant à :
faire que le premier système de traitement (50) informe le second système de traitement (60) d'un premier temps de cycle de processus pour traiter un substrat par le troisième processus,
faire que le second système de traitement (60) compare le premier temps de cycle de processus reçu en provenance du premier système de traitement (50) et un second temps de cycle de processus pour traiter un substrat par le deuxième processus, et
faire que le second système de traitement (60) sélectionne le plus long du premier et du second temps de cycle de processus pour utiliser le temps de cycle de processus sélectionné comme un intervalle de temps auquel les substrats sont transportés séquentiellement vers le premier système de traitement (50).

8. Procédé de traitement de substrat selon la revendication 5, comprenant en outre les étapes consistant à :
faire que le second système de traitement (60) informe le premier système de traitement (50) d'un second temps de cycle de processus pour traiter un substrat par le deuxième processus,
faire que le premier système de traitement (50) compare le second temps de cycle de processus et un premier temps de cycle de processus pour traiter un substrat par le troisième processus, et
faire que le premier système de traitement (50) sélectionne le plus long du premier et du second temps de cycle de processus pour utiliser le temps de cycle de processus sélectionné comme un intervalle de temps auquel les substrats sont transportés séquentiellement du premier système de traitement (50) au second système de traitement (60).
